# EUROPEAN PATENT APPLICATION

(11) **EP 0 605 980 A2**
(43) Date of publication of application: **13.07.1994**
(21) Application number: 93310235.2
(22) Date of filing: 17.12.1993
(51) Int. Cl.: H01L 21/314, H01L 21/318, C23C 16/50

(54) **Method for depositing silicon nitride and silicon oxynitride films**

(30) Priority: 07.01.1993 US 1456
(71) Applicant: RAMTRON INTERNATIONAL CORPORATION, Colorado Springs, Colorado 80921 (US)
(72) Inventor: Argos Jr., George, c/o Ramtron International Corp., Colorado Springs, CO 80921 (US); Patel, Divyesh N., c/o Ramtron International Corp., Colorado Springs, CO 80921 (US)
(74) Representative: Burke, Steven David

(57) **Abstract**

A method of depositing silicon nitride and silicon oxynitride films reacts tetraethoxysilane (TEOS) with nitrogen in a parallel plate chemical vapor deposition system. A high frequency power signal having a frequency of 13.56 MHz is applied to the upper plate (14) and the low frequency power signal having a frequency in the range of 100-400 KHz is applied to the lower plate (12). The degree of nitridization of the resulting film can be varied by adjusting the amount of power applied to the upper and lower plates.

## Description

This invention relates to a method for depositing silicon nitride and silicon oxynitride films, and more particularly, to an improved method of applying nitride films which have a low hydrogen content.

Two commonly used dielectric films in semiconductor devices are conventional plasma deposited silicon nitride and silicon oxide films. Silicon nitride has been extensively used as a passivation layer due to its desirable crack and scratch resistance, excellent qualities as a barrier to sodium impurities and moisture, conformal step coverage, and good process control characteristics. Silicon nitride is often used as an interlevel insulator, a dielectric coating for optical applications, and occasionally as a gate dielectric. Although silicon oxide has a lower dielectric constant, silicon oxide is generally more susceptible to impurity penetration and suffers from poor step coverage and batch uniformity control. As a result, the search for a dielectric film that could be used as both a passivation layer and an intermetal isolation layer for double metal VLSI technology leads to use of a plasma chemical vapor deposited (CVD) silicon oxynitride.

Both silicon nitride and silicon oxynitride often have a high hydrogen content. Conventional plasma deposited silicon nitride, made from various combinations of SiH₄/NH₃/N₂ gases, can contain up to 30% atomic hydrogen. Generally, the hydrogen causes instability in MOS devices by creating "traps" near the gate oxide. As a result, standard IC manufacturers are faced with the problem of threshold instability in short channel MOSFETs due to increased hot carrier injection caused by hydrogen released by the nitride and trapped at the gate oxide-silicon interface. Since the problem caused by hydrogen is believed to originate from the silicon-hydrogen bonds in the nitride, numerous attempts have been made to minimize the hydrogen content, or otherwise to avoid the harmful effects of the silicon-hydrogen bonds.

One current way of reducing the hydrogen content in plasma deposited silicon nitride films is to use diluted silane (SiH₄) as one of the reactants. Another way involves the use of fluorinated amorphous silicon material. It is believed that the fluorine incorporated in the silicon lends stability and reduces dangling bonds. For example, a combination of NF₃/SiH₄/N₂ gases can be used to form the nitride layer. Variations in this gas combination provide for independent control of silicon and fluorine content. Fluorinated silicon nitride films exhibit electrical and optical properties that compare favorably to thermal CVD silicon nitride formed using an NH₃ inert gas carrier.

As is apparent, these methods to reduce hydrogen content have focused primarily at modifying standard silane-based nitride deposition. However, even these methods of depositing nitride and oxynitride Films release enough hydrogen to degrade CMOS circuitry. This problem of a high hydrogen content formed in nitrides is particularly significant when incorporating ferroelectric material, which is highly sensitive to hydrogen, into a semiconductor device.

An object of the present invention is to overcome the problem of high hydrogen content in silicon nitride films and silicon oxynitride films.

A further object of the present invention is to control the ratio of oxygen to nitrogen in an oxynitride film having low hydrogen content.

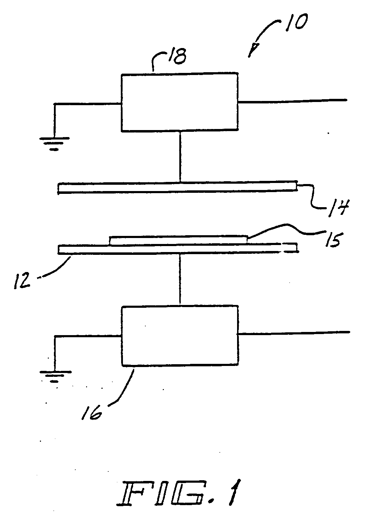

The present invention is directed to a novel method for the deposition of silicon nitride or oxynitride films using tetraethoxysilane (TEOS) as the silicon source to reduce the hydrogen content of the film. The present invention preferably utilizes a dual frequency parallel plate chemical vapor deposition (CVD) system, as shown for example in Figure 1. In the method of the present invention, a high frequency signal is applied to the top electrode or upper plate for excitation of the reactants and a low frequency signal is applied to the susceptor or lower plate to control ion bombardment in the apparatus. The amount of power applied to the upper plate and to the lower plate can be varied to control the degree of nitridization of the film. As the film becomes more of a nitride than an oxide, the etch rate generally decreases, while the refractive index, the film hardness and the dielectric constant generally increase. In addition, the nitride film is a better barrier to mobile ions.

Because the amount of oxygen and nitrogen in the film is determined by the ratio of high frequency power/low frequency power applied to the plates, it is possible by using the present invention to produce oxynitride films having different oxide/nitride ratios. The invention includes the step of having a high nitrogen flow, preferably 5,000 sccm, during deposition to prevent oxygen present in the TEOS from dominating the reaction and forming SiO₂ regardless of the power levels. Finally, a separate N₂ anneal step can be performed at 1100°C after the film is deposited, although this step is not required.

The present invention allows for the deposition of silicon nitride or oxynitride films having a much lower hydrogen content than the prior art methods which use silicon nitride or oxynitride films. Consequently, integrated circuit chips to be passivated with nitride or oxynitride films based on the method of the present invention will provide a barrier to moisture and alkali ion impurity penetration and exhibit scratch resistance, but will not exhibit degradation resulting from high hydrogen content as in semiconductor devices in the prior art.

Figure 1 is a typical parallel plate plasma enhanced chemical vapor deposition apparatus.

The present invention is directed to a method of depositing nitride and oxynitride films by plasma enhanced chemical vapor deposition (PECVD). While prior methods for producing PECVD nitride films employed a reactant species consisting of SiH₄(silane), NH₃ and N₂, in the method of the present invention, Si(OC₂H₅)₄ (TEOS) is used as a reactant species for producing the PECVD nitride films instead of SiH₄ (silane) and NH₃ which are used in the prior methods. In addition, a high nitrogen flow, preferably 5000 sccm, is used during the deposition of the nitride films to prevent oxygen from dominating the reaction and forming SiO₂ regardless of the power applied to the upper and lower plates. The reaction of TEOS with N₂ to generate a low hydrogen content film can be expressed as follows:

Si(OC₂H₅)₄ + N₂ → SiₓN_{y}O_{z} + C₂H₄ + H₂O

Additionally, waste oxygen or nitrogen may be produced. Although the gas flows could be varied, the gas flows are preferably kept constant during the deposition of the film. Generally, greater N₂ flow leads to a film having a higher nitride content while having a lower hydrogen content. A higher TEOS flow generally leads to a film having a lower nitride content. Adjusting the flow of TEOS does not affect the hydrogen content. However, the deposition rate is severely decreased if the gas flows are too low.

The method of the present invention for depositing nitride and oxynitride films preferably employs a typical dual frequency plasma enhanced chemical vapor deposition (PECVD) system, such as the Novellus Concept One PECVD reactor. This PECVD reactor is disclosed, for example, in R.E. Martin et al. "RF Bias To Control Stress and Hydrogen in PECVD Nitride," Proceedings of 5th I.E.E.E. V.M.I.C. Conference (June, 1988), which is incorporated by reference as background art.

A typical dual frequency PECVD system 10 (shown in Figure 1) includes a process chamber having a lower plate or susceptor 12 and a parallel upper plate 14. The degree of nitridization (i.e. the amount of nitrogen in the SiₓN_{y}O_{z}) of the resulting film in the present invention is controlled by adjusting the power levels of the upper and lower plates of the CVD system. The degree of nitridization is defined by the ratio of the power of the signals applied to the upper/lower plates in watts. Preferably, the spacing between the plates is approximately .5 inches (12.8 mm), and the pressure in the process chamber is preferably maintained at a pressure of 3 Torr. Although 3 Torr may give the best uniformity, a range of 2 Torr to 4.2 Torr is acceptable.

The wafers 15 receiving a layer of nitride or oxynitride film are placed on lower plate or susceptor during chemical vapor deposition. The lower plate is connected to a low pass filter 16 for passing low frequency power to the lower plate. The low frequency signal is applied to the lower plate to control the degree of ion bombardment of the reactants in the chamber. Preferably, the low frequency power signal applied to the lower plate has a frequency between 100 and 400 KHz, while the lower plate is maintained at 400°C. Typically, the wafer gets heated to about 390°C due to good thermal coupling between the wafer and the lower plate. Increasing the temperature of the lower plate will increase the degree of nitridization (i.e., nitrogen content of the film) and decrease the amount of hydrogen in the film.

The upper plate is connected to a high pass filter 18 for passing high frequency RF power to the upper plate. Gases and RF power are distributed through seven showerheads in the upper plate. The high frequency signal, preferably having a frequency of approximately 13.56 MHz, is continuously applied to the upper plate for the excitation of the reactants in the process chamber.

As mentioned supra, properties of the film (for example, the ratio of oxygen to nitrogen in the film or the hydrogen content of the film) are determined by the ratio of high frequency power/low frequency power signals applied to the plates. Because the high and low frequency power signals can be controlled independently, the amount of power applied to the upper plate and to the lower plate can be varied to control the degree of nitridization and the hydrogen content of the film. For example, a deposition employing a low frequency signal having 500 watts of power applied to the lower plate and a high frequency signal having 250 watts of power applied to the upper plate would result in a high frequency/low frequency power ratio of 250/500 or 0.50.

As the ratio of high frequency power to low frequency power approaches zero, the hydrogen content decreases. In addition, the film becomes more of a nitride as their ratio approaches zero. Therefore, it is possible to adjust the power levels of the high frequency and low frequency signals applied to the upper and lower plates to obtain a film having any desired content of nitride or oxynitride or a film having a certain hydrogen content.

The preferred film for use with ferroelectric devices would have a high nitrogen content and a low hydrogen content. Therefore, power levels of 800 watts of low frequency power (preferably at a minimum frequency determined by the system) applied to the lower plate (maintained at a maximum temperature determined by the system) and 0 watts of high frequency power applied to the upper plate.

Although the upper and lower frequencies themselves can be varied, the frequencies are preferably kept constant during the deposition. Preferably, the signal on the upper plate is maintained at approximately 13.56 MHz. Varying the frequency of the signal applied to the lower plate has been found to have a very minimal effect on the film. For example, by varying the frequency on the lower plate from 450 KHz to 100 KHz, the resulting film was found to contain slightly more nitrogen, thus tending to be more of a nitride. Varying the frequency on the lower plate is found to have no effect on the hydrogen content.

Generally, the time of reaction effects the resulting thickness of the film and can be adjusted according to a desired thickness. Finally, after the film is deposited, an N₂ anneal can be performed. If an annealing step is performed, the annealing is preferably performed at approximately 1100°C.

The method of the present invention is beneficial over the prior methods for a number of reasons. For example, the method of the present invention can be used to produce a film that can be used as a passivating layer for integrated circuits while not inducing threshold instability caused by the release of hydrogen from the passivation layer to the gate oxide-silicon interface. The method can also be used to form an oxide-nitride-oxide (ONO) layer for EPROMS. In addition, the method can produce a silicon oxynitride film that acts as a barrier against oxygen diffusion, allowing the film to be used as a mask in growing thermal oxides in unmasked areas. This film can also be used in a "dep-etch-dep" technique for planarizing an intermetal dielectric.

The film produced using the method of the present invention can further be beneficial for passivating ferroelectric devices, which are highly sensitive to hydrogen released from the passivation layer. For example, the film can be used for capping the underlying flow glass (isolating the polysilicon from the first level metal) in a ferroelectric IC process to prevent lead in the PZT from doping the flow glass and causing voiding. A dielectric layer of silicon oxynitride produced by the method of the present invention can be used to form a spacer around a polysilicon line or around a PZT capacitor stack. Because of the low hydrogen content of the resulting nitride or oxynitride, the film does not degrade the ferroelectric switching of the PZT capacitor by releasing hydrogen when subjected to high temperatures. While standard nitride causes 100% switched charge loss at a temperature of 400°C and the method of depositing films employing silane in a dual frequency chamber causes 90% switched charge loss, the method of the present invention has shown significant improvement by causing only 5% switched charge loss.

It is believed that the deposition method of the present invention results in a very dense film due to the slow deposition rate and the use of low frequency power which tends to drive ions into the film. This results in a film with a very slow etch rate. A slow etch rate can be beneficial in the formation of semiconductor devices for a number of reasons. A slow etch rate dielectric layer can be used as an etch stop for contact etching. Further, a slow etch rate dielectric layer can be used to control the contact opening and via opening profiles for improved metal step coverage. A series of consecutive layers can be deposited by varying the composition of TEOS, N₂, TMP (trimethylphosphite), TMB (trimethylborate) or O₂ (if needed). A tapered profile of the contact and via openings for better metal step coverage is obtained by depositing layers having increasing etch rate from the bottom or lower surface to the top. The increasing etch rate in successive layers of the dielectric can be achieved by varying the amount of boron and phosphorus dopants incorporated into the film by varying the flow rates of the TMB and TMP reactants.

The ferroelectric ICs including silicon nitride or oxynitride films deposited by the method of the present invention have shown minimal ferroelectric degradation even after 16 hours at 350°C. Consequently, integrated circuit chips to be passivated with a nitride films produced by the present invention will provide a barrier to moisture and alkali ion impurity penetration, scratch resistance, as well as a lower hydrogen level compared to chips employing a nitride film produced by a prior method.

The following table compares oxynitride film deposited according to method of the present invention with a standard SiO₂ film and a standard Si₃N₄ film. The nitos film is deposited according to the following parameters:
- N₂ =: 5000 sccm
- TEOS =: 1.8 sccm
- POWER =: 600 W low frequency (200 KHz)
0 W high frequency
- TEMP. =: 420°C
- PRES. =: 3.0 Torr
- TIME =: 4.7 min.

| NITOS RESULTS/COMPARISON | | | |
|---|---|---|---|
| | Std. SiO₂ (UTEOS) | Std. Si₃N₄ | NITOS |
| Refr. Index | 1.45 | 2.0 | 1.55-1.7 |
| Wet Etch Rate 7:1 E.O.E. | 1622 Å/m | 200-400 Å/m | 145 Å/m |
| Wet Etch Rate 20:1 B.O.E. | 737 Å/m | 150 Å/m | 70-110 Å/m |
| Stress | low 10⁹C | High Tensile | low 10⁸C |
| Hardness | Easy to Scratch | Difficult to Scratch | Difficult to Scratch |
| H2 Content | Low | High | Low |

While this invention has been described with reference to an illustrative embodiment, it will be understood that this description is not intended to be construed in a limiting sense, but is intended to include any substitutes within the spirit and scope of the invention as defined by the appended claims. For example, films formed by the novel deposition technique of the present invention can be used as a hard coating for macroscopic objects such as tools because of the hard qualities exhibited by the films. Also, it may be feasible to use a different alkyl, such as methyl, in place of the ethyl in the TEOS, i.e. to use tetra-alkoxysilane. Various modifications of the illustrative embodiment, as well as other embodiments of the invention, will become apparent to those skilled in the art upon reference to this description.

## Claims

1. A method of depositing a silicon nitride film in a parallel plate chemical vapor deposition system having an upper (14) and lower plate (12) characterized by the steps of positioning a wafer between the upper and lower plates; applying power to at least one of said plates; and reacting tetraethoxysilane with nitrogen between said plates to form silicon nitride having a predetermined nitrogen and oxygen content.

2. The method of depositing a silicon nitride film of Claim 1 further characterized by the step of annealing the film after reacting tetraethoxysilane with nitrogen.

3. The method of depositing a silicon nitride film of Claim 2 further characterized by the step of annealing the film is performed in an N₂ environment at 1100°C.

4. The method of depositing a silicon nitride film of Claim 1 further characterized by a high frequency power signal being applied to the upper plate (14) and a low frequency power signal being applied to the lower plate (12).

5. The method of depositing a silicon nitride film of Claim 4 further characterized by the high frequency power signal having a frequency of 13.56 MHz and the low frequency power signal having a frequency of 100-400 KHz.

6. The method of depositing a silicon nitride film of Claim 1 further characterized by the lower plate (12) being maintained at 400°C.

7. The method of depositing a silicon nitride film of Claim 1 further characterized by the flow of tetraethoxysilane being at a rate of 1.8 sccm and the flow of nitrogen being at a rate of 5000 sccm through the upper plate in the system.

8. The method of depositing a silicon nitride film of Claim 1 further characterised by the pressure in the chemical vapor deposition system being maintained between 2.0 and 4.2 Torr.

9. A method of forming a film by reacting tetra-alkoxysilane with nitrogen.

10. A semiconductor device having a silicon(oxy)nitride layer formed by reacting tetra-alkoxysilane with nitrogen.

11. A ferroelectric memory having a passivation layer formed by reacting tetra-alkoxysilane with nitrogen.
